(19)

**Europäisches Patentamt**
**European Patent Office**
**Office européen des brevets**

(11)  **EP 4 611 257 A1**

(12)  # EUROPEAN PATENT APPLICATION

(43) Date of publication:
**03.09.2025  Bulletin 2025/36**

(21) Application number: **24202890.0**

(22) Date of filing: **26.09.2024**

(51) International Patent Classification (IPC):
***H02S 50/10*** *(2014.01)*

(52) Cooperative Patent Classification (CPC):
**H02S 50/10;** Y02E 10/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2024  CN 202410224618**

(71) Applicant: **Sungrow Power Supply Co., Ltd.
Hefei, Anhui 230088 (CN)**

(72) Inventors:
• **HU, Fanyu
  Hefei, 230088 (CN)**
• **PAN, Nianan
  Hefei, 230088 (CN)**
• **CAO, Jinhu
  Hefei, 230088 (CN)**

(74) Representative: **Zacco Norway AS
P.O. Box 488 Skøyen
0213 Oslo (NO)**

(54)  **PHOTOVOLTAIC POWER GENERATION SYSTEM AND INSULATION DETECTION METHOD**

(57)    A photovoltaic power generation system and an insulation detection method are provided. The system includes a switch, a DC-AC circuit, a controller and at least one DC-DC circuit. An input end of each of the at least one DC-DC circuit is configured to connect n photovoltaic strings, n is an integer greater than or equal to two, and an output end of the at least one DC-DC circuit is connected to an input end of the DC-AC circuit. Negative electrodes of all the photovoltaic strings are grounded through the switch. The controller is configured to close the switch and determine a photovoltaic string where an insulation fault occurs based on a magnitude and a direction of a current of each of the n photovoltaic strings, if the insulation fault occurs at a positive electrode of the photovoltaic power generation system to ground. If an insulation fault occurs at the positive electrode of the photovoltaic power generation system, the negative electrodes of all the photovoltaic strings are controlled to be grounded, and a short circuit occurs between a positive electrode of a photovoltaic string where the insulation fault occurs and the ground. As a result, a current path is formed between the positive electrode of the photovoltaic string and the ground, and currents of other photovoltaic strings flow into the photovoltaic string where the insulation fault occurs, in a direction opposite to a direction of a current of the photovoltaic string where the insulation fault occurs, so that the photovoltaic string where the insulation fault occurs can be determined.

**Figure 2**

## Description

### FIELD

The present disclosure relates to the technical field of insulation fault detection, and in particular to a photovoltaic power generation system and an insulation detection method.

### BACKGROUND

A photovoltaic power generation system includes photovoltaic strings, a DC-DC circuit and an inverter circuit. Generally, an input end of the inverter circuit is connected to multiple DC-DC circuits, and an input end of each of the multiple DC-DC circuits is connected to multiple photovoltaic strings connected in parallel.

During operation, an insulation fault may occur in a photovoltaic string, causing safety hazards to the operation of the photovoltaic power generation system. Therefore, insulation fault detection is usually performed on the photovoltaic power generation system.

In the conventional technology, whether an insulation fault occurs in the photovoltaic power generation system is determined by detecting an insulation impedance of the photovoltaic power generation system to ground. And, if the insulation fault occurs in the photovoltaic power generation system, a photovoltaic string where the insulation fault occurs fails to be determined, which is not conducive to on-site troubleshooting of the insulation fault.

### SUMMARY

In view of this, a photovoltaic power generation system and an insulation detection method are provided according to the present disclosure, to accurately determine a photovoltaic string where an insulation fault occurs.

A photovoltaic power generation system is provided according to an embodiment of the present disclosure. The photovoltaic power generation system includes a switch, a DC-AC circuit, a controller and at least one DC-DC circuit. An input end of each of the at least one DC-DC circuit is configured to connect n photovoltaic strings, where n is an integer greater than or equal to two; an output end of the at least one DC-DC circuit is connected to an input end of the DC-AC circuit; negative electrodes of all the photovoltaic strings are grounded through the switch; and the controller is configured to close the switch and determine a photovoltaic string where an insulation fault occurs based on a magnitude and a direction of a current of each of the n photovoltaic strings, if the insulation fault occurs at a positive electrode of the photovoltaic power generation system to ground.

In an embodiment, the photovoltaic power generation system according to the embodiment of the present disclosure further includes at least n-1 current detection devices. Positive electrodes of the n photovoltaic strings are connected to each other. Each of the at least n-1 current detection devices is connected between a positive electrode of a corresponding photovoltaic string and a positive junction corresponding to the photovoltaic string, and the current detection device is configured to detect a current of a branch where the photovoltaic string is located.

In an embodiment, the controller is configured to determine, if a current of an i-th photovoltaic string is detected as positive, that the insulation fault occurs at a positive electrode of the i-th photovoltaic string to the ground, where the i-th photovoltaic string is one of the n photovoltaic strings.

In an embodiment, the photovoltaic power generation system further includes n-1 current detection devices. Positive electrodes of the n photovoltaic strings are connected to each other to form n-1 positive junctions. n-2 current detection devices among the n-1 current detection devices each are connected between two adjacent positive junctions among the n-1 positive junctions, and the remaining one current detection device among the n-1 current detection devices is connected between a positive electrode of a first photovoltaic string and a positive junction corresponding to a second photovoltaic string.

In an embodiment, the controller is configured to determine, if a current of an i-th photovoltaic string is detected as positive and an absolute value of the current is maximum, that the insulation fault occurs at a positive electrode of the i-th photovoltaic string to the ground, where the i-th photovoltaic string is one of the n photovoltaic strings.

In an embodiment, a negative input terminal and a negative output terminal of the at least one DC-DC circuit are connected to each other.

In an embodiment, a negative input terminal and a negative output terminal of the at least one DC-DC circuit are disconnected from each other.

In an embodiment, the photovoltaic power generation system further includes a current limiting device. The number of the current limiting device, the number of the switch and the number of the at least one DC-DC circuit are equal to each other. The current limiting device and the switch are connected in series in one-to-one correspondence to form a branch, and the branch is connected between the negative input terminal of the corresponding DC-DC circuit and the ground.

In an embodiment, the photovoltaic power generation system further includes a current limiting device. The number of the current limiting device and the number of the switch each are one. The current limiting device and the switch are connected in series to form a branch, and the branch is connected between the negative input terminal or the negative output terminal of the at least one DC-DC circuit and the ground.

An insulation detection method for a photovoltaic power generation system is further provided according to an embodiment of the present disclosure. The photovoltaic power generation system includes a switch, a DC-AC circuit and at least one DC-DC circuit. An input end of each of the at least one DC-DC circuit is configured to connect n photovoltaic strings, n is an integer greater than or equal to two, and an output end of the at least one DC-DC circuit is connected to an input end of the DC-AC circuit; and negative electrodes of all the photovoltaic strings are grounded through the switch. The insulation detection method includes: determining whether an insulation fault occurs at a positive electrode of the photovoltaic power generation system to ground based on an insulation impedance of the photovoltaic power generation system to the ground; and closing the switch and determining a photovoltaic string where the insulation fault occurs based on a magnitude and a direction of a current of each of the n photovoltaic strings, if the insulation fault occurs at the positive electrode of the photovoltaic power generation system to the ground.

In an embodiment, the photovoltaic power generation system further includes at least n-1 current detection devices. Positive electrodes of the n photovoltaic strings are connected to each other, each of the at least n-1 current detection devices is connected between a positive electrode of a corresponding photovoltaic string and a positive junction corresponding to the photovoltaic string, and the current detection device is configured to detect a current of a branch where the photovoltaic string is located. The determining a photovoltaic string where the insulation fault occurs based on a magnitude and a direction of a current of each of the n photovoltaic strings includes: determining, if a current of an i-th photovoltaic string is detected as positive, that the insulation fault occurs at a positive electrode of the i-th photovoltaic string to the ground, where the i-th photovoltaic string is one of the n photovoltaic strings.

In an embodiment, the photovoltaic power generation system further includes n-1 current detection devices. Positive electrodes of the n photovoltaic strings are connected to each other to form n-1 positive junctions. n-2 current detection devices among the n-1 current detection devices each are connected between two adjacent positive junctions of the n-1 positive junctions, and the remaining one current detection device among the n-1 current detection devices is connected between a positive electrode of a first photovoltaic string and a positive junction corresponding to a second photovoltaic string. The determining a photovoltaic string where the insulation fault occurs based on a magnitude and a direction of a current of each of the n photovoltaic strings includes: determining, if a current of an i-th photovoltaic string is detected as positive and an absolute value of the current is maximum, that the insulation fault occurs at a positive electrode of the i-th photovoltaic string to the ground, where the i-th photovoltaic string is one of the n photovoltaic strings.

It can be seen that the present disclosure has the following beneficial effects.

In the photovoltaic power generation system according to the embodiments of the present disclosure, if an insulation fault occurs at the positive electrode of the photovoltaic power generation system, the negative electrodes of all the photovoltaic strings are controlled to be grounded, and a short circuit occurs between a positive electrode of a photovoltaic string where the insulation fault occurs and the ground. As a result, a current path is formed between the positive electrode of the photovoltaic string and the ground, and currents of other photovoltaic strings flow into the photovoltaic string where the insulation fault occurs, in a direction opposite to a direction of a current of the photovoltaic string where the insulation fault occurs. Therefore, the photovoltaic string where the insulation fault occurs can be determined by detecting a magnitude and a direction of the current of each of the photovoltaic strings according to the embodiments of the present disclosure.

**BRIEF DESCRIPTION OF THE DRAWINGS**

Figure 1 is a schematic diagram of a photovoltaic power generation system according to an embodiment of the present disclosure;

Figure 2 is a schematic diagram of a photovoltaic power generation system according to another embodiment of the present disclosure;

Figure 3 is a schematic diagram of a photovoltaic power generation system according to another embodiment of the present disclosure;

Figure 4 is a schematic diagram of a photovoltaic power generation system in common negative connection according to an embodiment of the present disclosure;

Figure 5 is a schematic diagram of a photovoltaic power generation system not in common negative connection according to an embodiment of the present disclosure;

Figure 6 is a schematic diagram of a photovoltaic power generation system in common negative connection according to another embodiment of the present disclosure;

Figure 7 is a schematic diagram of a photovoltaic power generation system in common negative connection according to another embodiment of the present disclosure;

Figure 8 is a schematic diagram of a photovoltaic power generation system not in common negative connection according to another embodiment of the present disclosure; and

Figure 9 is a flowchart of an insulation detection method for a photovoltaic power generation system according to an embodiment of the present disclosure.

## DETAILED DESCRIPTION OF THE EMBODIMENTS

In order to make the above objective, features and advantages of the present disclosure more apparent and understandable, hereinafter, the embodiments of the present disclosure are described in further detail in combination with the drawings and specific implementations.

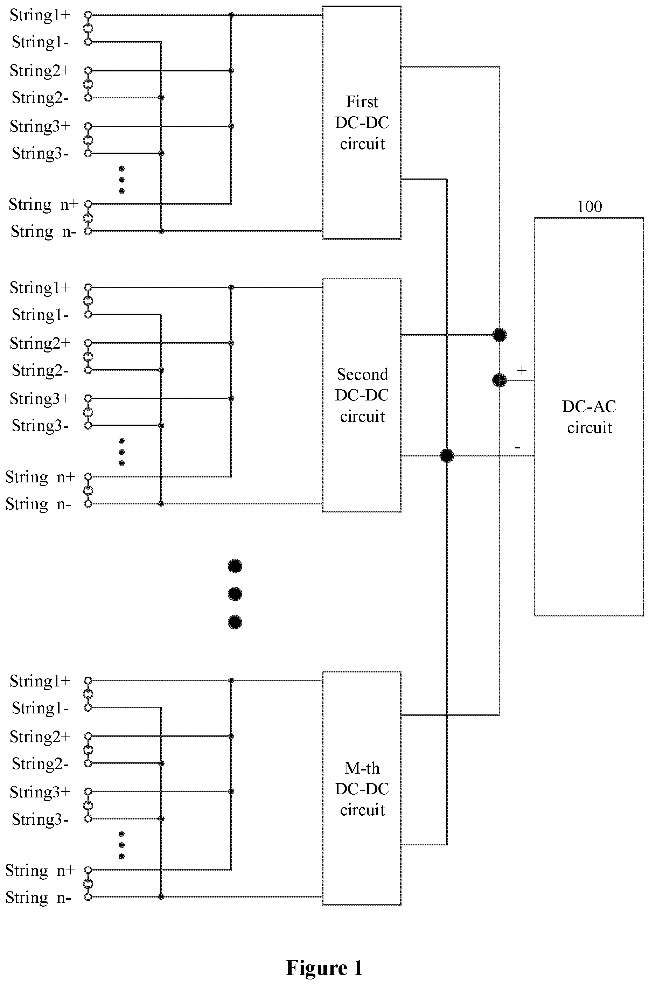

Reference is made to Figure 1, which is a schematic diagram of a photovoltaic power generation system according to an embodiment of the present disclosure.

In the embodiment of the present disclosure, the photovoltaic power generation system includes a DC-AC circuit 100 and at least one DC-DC circuit.

The number of the DC-DC circuit is not specifically limited in the embodiment of the present disclosure. That is, an input end of the DC-AC circuit is connected to one DC-DC circuit or multiple DC-DC circuits. In addition, the number of the DC-AC circuit 100 provided in the photovoltaic power generation system is not specifically limited in the embodiment of the present disclosure. The photovoltaic power generation system includes one DC-AC circuit or multiple DC-AC circuits. To facilitate description, the following embodiments are described by taking one DC-AC circuit as an example.

As shown in Figure 1, an input end of the DC-AC circuit 100 is connected to M DC-DC circuits as an example.

For example, an input end of each of the DC-DC circuits is configured to connect n photovoltaic strings, where n is an integer greater than or equal to two, and output ends of the M DC-DC circuits are connected to the input end of the DC-AC circuit 100. As shown in Figure 1, a first DC-DC circuit is described as an example. String 1+ and String 1- represent a positive electrode and a negative electrode of a first photovoltaic string (a first photovoltaic string from a positive electrode towards a negative electrode of the first DC-DC circuit is taken as the first photovoltaic string) respectively, String2+ and String2- represent a positive electrode and a negative electrode of a second photovoltaic string respectively, String3+ and String3- represent a positive electrode and a negative electrode of a third photovoltaic string respectively, ..., and String n+ and String n- represent a positive electrode and a negative electrode of an n-th photovoltaic string respectively. Similar to the first DC-DC circuit, each of a second DC-DC circuit, ..., to an M-th DC-DC circuit is connected to corresponding photovoltaic strings, which is not described in detail herein.

In the embodiment of the present disclosure, the number of photovoltaic strings connected to the input end of each of the DC-DC circuits is identical. In other embodiments, the number of photovoltaic strings connected to an input end of a DC-DC circuit is different from the number of photovoltaic strings connected to the input end of another DC-DC circuit.

The input end of the DC-DC circuit is connected to multiple photovoltaic strings. As a result, if an insulation fault occurs in a photovoltaic string to the ground, the photovoltaic string fails to be determined, i.e., the photovoltaic string where the insulation fault to the ground occurs fails to be accurately determined.

A solution for determining a photovoltaic string where the insulation fault to the ground occurs is provided according to the embodiment of the present disclosure as follows. If it is detected that an insulation fault occurs at a positive electrode of the photovoltaic power generation system to the ground, the photovoltaic power generation system is controlled to stop operating, negative electrodes of all the photovoltaic strings are controlled to be grounded, and the photovoltaic string where the insulation fault to the ground occurs is directly determined based on a magnitude and a direction of a current of each of the photovoltaic strings.

The solution is described in detail in conjunction with the drawings hereinafter.

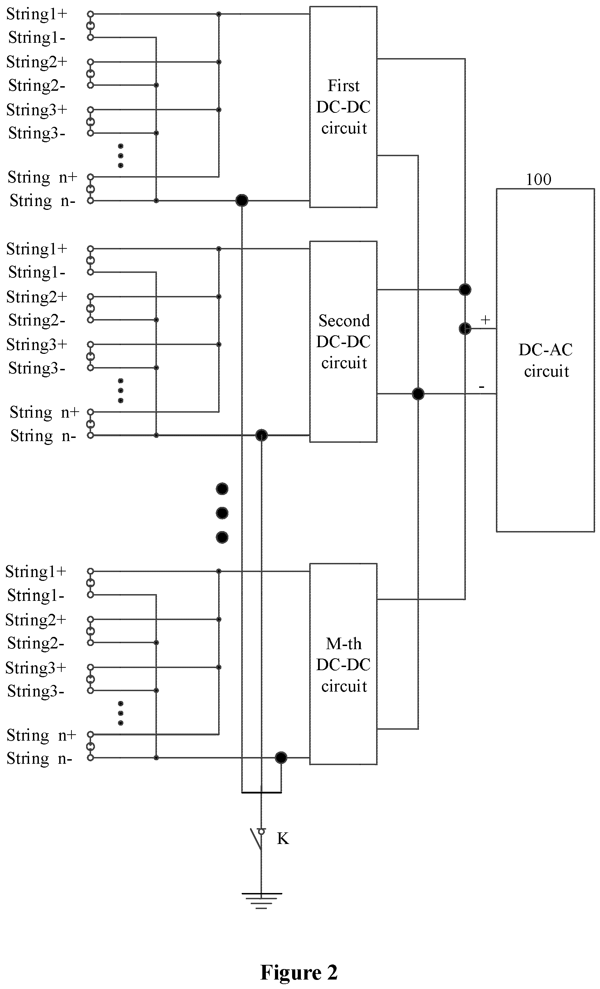

Reference is made to Figure 2, which is a schematic diagram of a photovoltaic power generation system according to another embodiment of the present disclosure.

The photovoltaic power generation system according to the embodiment of the present disclosure includes a switch K, a DC-AC circuit 100, a controller and at least one DC-DC circuit. The number of the at least one DC-DC circuit is not specifically limited in the embodiment of the present disclosure. That is, the input end of the DC-AC circuit 100 is connected to one DC-DC circuit or multiple DC-DC circuits.

An input end of each of the at least one DC-DC circuit is configured to connect n photovoltaic strings, where n is an integer greater than or equal to two. An output end of the at least one DC-DC circuit is connected to the input end of the DC-AC circuit 100.

Negative electrodes of all photovoltaic strings are grounded through the switch K. Each DC-DC circuit is individually described as follows. The input end of each of the DC-DC circuits is connected to corresponding n photovoltaic strings. A positive input terminal of a first DC-DC circuit is connected to positive electrodes of corresponding n photovoltaic strings, and a negative input terminal of the first DC-DC circuit is connected to negative electrodes of the n photovoltaic strings. The negative electrodes of the n photovoltaic strings are grounded through the switch K, that is, the negative input terminal of the first DC-DC circuit is grounded through the switch K. Similarly, a positive input terminal of a second DC-DC circuit is connected to positive electrodes of corresponding n photovoltaic strings, and a negative input terminal of the second DC-DC circuit is connected to negative electrodes of the n photovoltaic strings. The negative electrodes of the n photovoltaic strings are grounded through the switch K, that is, the negative input terminal of the second DC-DC circuit is grounded through the switch K. Similarly, a positive input terminal of an M-th DC-DC circuit is connected to positive electrodes of corresponding n photovoltaic strings, and a negative input terminal of the M-th DC-DC circuit is connected to negative electrodes of the n photovoltaic strings. The negative electrodes of the n photovoltaic strings are grounded through the switch K, that is, the negative input terminal of the M-th DC-DC circuit is grounded through the switch K.

The controller (not shown in Figure 2) is configured to close the switch K and determine a photovoltaic string where an insulation fault occurs based on a magnitude and a direction of a current of each of the photovoltaic strings, if the insulation fault occurs at a positive electrode of the photovoltaic power generation system to the ground.

The type of the switch K is not specifically limited in the embodiment of the present disclosure, and the controller may control an on-off state of the switch K.

It should be understood that, if an insulation fault occurs in the photovoltaic power generation system to ground, it is determined whether the insulation fault occurs based on an insulation impedance of the photovoltaic power generation system to the ground. For example, if the insulation impedance of the photovoltaic power generation system to the ground is less than a preset impedance, it indicates that the insulation fault occurs. According to the embodiment of the present disclosure, if the insulation fault occurs at the positive electrode of the photovoltaic power generation system, the insulation fault is further accurately located.

If the insulation fault occurs at the positive electrode of the photovoltaic power generation system, the negative electrodes of all the photovoltaic strings are controlled to be grounded, and a short circuit occurs between a positive electrode of a photovoltaic string where the insulation fault occurs and the ground. As a result, a current path is formed between the positive electrode of the photovoltaic string and the ground, and currents of other photovoltaic strings flow into the photovoltaic string where the insulation fault occurs, in a direction opposite to a direction of a current of the photovoltaic string where the insulation fault occurs. Therefore, the photovoltaic string where the insulation fault occurs can be determined by detecting the magnitude and the direction of the current of each of the photovoltaic strings according to the embodiments of the present disclosure.

To facilitate description, one DC-DC circuit connected to n photovoltaic strings is taken as an example in the following description. The solution for locating an insulation fault is also suitable for a scenario that multiple DC-DC circuits are provided.

The photovoltaic power generation system according to the embodiment of the present disclosure further includes a current limiting device. The current limiting device may be a current limiting resistor or a current limiting inductor. In the embodiment of the present disclosure, the current limiting device is the current limiting resistor.

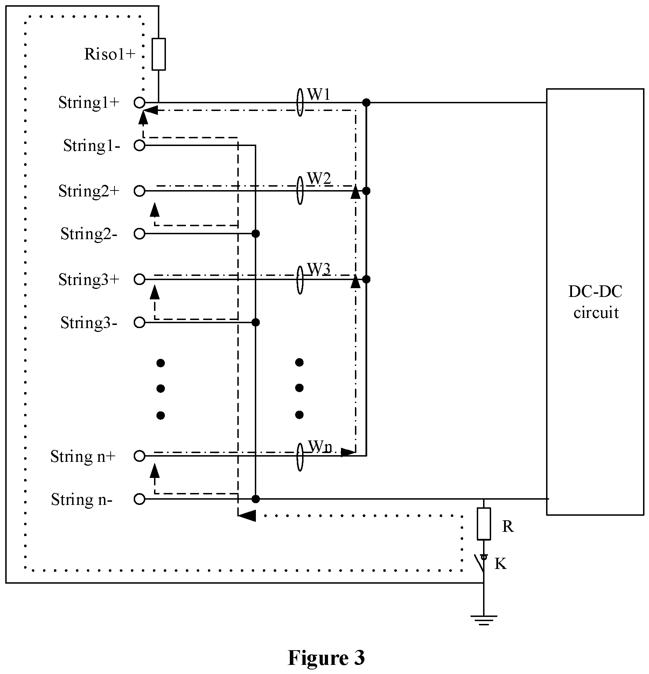

Reference is made to Figure 3, which is a schematic diagram of a photovoltaic power generation system according to another embodiment of the present disclosure.

For example, in the photovoltaic power generation system, an insulation fault occurs at a positive electrode of one of photovoltaic strings connected to one DC-DC circuit to ground. String n+ and String n- represent a positive electrode and a negative electrode of an n-th photovoltaic string respectively. W1 to Wn represent current detection devices for the first photovoltaic string to the n-th photovoltaic string respectively. Riso represents an equivalent impedance of the positive electrode to the ground, and K represents a switch (the switch K may be a device, such as a relay, or a power switch which can be closed or opened) through which negative electrodes are grounded. R represents a current limiting resistor. The current limiting resistor R is connected to the switch K in series to form a branch, and the branch is grounded. It may be understood that, the current limiting resistor R may be not provided or replaced by an inductor, or both the current limiting resistor R and the inductor are provided.

If an insulation fault occurs at a positive electrode of the first photovoltaic string to the ground, the equivalent impedance Riso is less than a safety threshold of the insulation impedance, the switch K is closed, and a current path is formed between each photovoltaic string and the ground. As shown in Figure 3, dash dot lines illustrate current paths of normal photovoltaic strings (the second photovoltaic string to the n-th photovoltaic string) where no insulation fault occurs, dashed lines illustrate a current path of the photovoltaic string (the first photovoltaic string) where the insulation fault occurs, and a dotted line illustrates a common current path. It can be seen from the current paths that, a current detected by a current detection device for the first photovoltaic string is equal to a sum of currents detected by current detection devices for other normal photovoltaic strings, and is in a direction opposite to a direction of the currents of other normal photovoltaic strings, so that it is determined that the insulation fault occurs at the positive electrode of the first photovoltaic string.

Similarly, if an insulation fault occurs at a positive electrode of the n-th photovoltaic string, a current detected by the current detection device for the n-th photovoltaic string is in a direction opposite to a direction of currents detected by current detection devices of other normal photovoltaic strings, and the current of the n-th photovoltaic string is a sum of the currents of the other normal photovoltaic strings.

For example, the DC-DC circuit is connected to five photovoltaic strings. If an insulation fault occurs at a positive electrode of the first photovoltaic string, the second photovoltaic string, the third photovoltaic string, the fourth photovoltaic string, or the fifth photovoltaic string to the ground, the currents detected by the current detection devices for various photovoltaic strings are shown in Table 1.

Table 1. Currents of photovoltaic strings if a short circuit occurs between a positive electrode of a photovoltaic string and the ground

|  | W1 | W2 | W3 | W4 | W5 |
|---|---|---|---|---|---|
| First photovoltaic string | -2.0A | 0.5A | 0.5A | 0.5A | 0.5A |
| Second photovoltaic string | 0.5A | -2.0A | 0.5A | 0.5A | 0.5A |
| Third photovoltaic string | 0.5A | 0.5A | -2.0A | 0.5A | 0.5A |
| Fourth photovoltaic string | 0.5A | 0.5A | 0.5A | -2.0A | 0.5A |
| Fifth photovoltaic string | 0.5A | 0.5A | 0.5A | 0.5A | -2.0A |

From currents detected by various current detection devices in Table 1, it can be seen that if the current detection device W1 for the first photovoltaic string is not provided, and the currents detected by the current detection devices W2, W3, W4 and W5 are all positive, it is determined that an insulation fault occurs at the positive electrode of the first photovoltaic string. Therefore, at least four current detection devices are provided to locate an insulation fault among the five photovoltaic strings. Correspondingly, if one DC-DC circuit is connected to n photovoltaic strings, at least n-1 current detection devices are provided.

The type of the current detection device is not limited in the embodiments of the present disclosure. For example, the current detection device may be a current sensor, a current transformer or the like.

In an embodiment, the following example is provided to further improve the detection precision of the insulation impedance. An input voltage of the DC-DC circuit is Vpv, a sum of the currents of the normal photovoltaic strings is Isum, and a current limiting resistor connected to the switch has resistance R. An insulation impedance Riso+ of the positive electrode to the ground is calculated according to Ohm's law as:

$$Riso+=Vpv/Isum-R$$

In general, the photovoltaic power generation system includes multiple DC-DC circuits. An implementation in which the multiple DC-DC circuits are in common negative connection is described hereinafter.

In the photovoltaic power generation system according to the embodiments of the present disclosure, the solution for locating an insulation fault varies with a location of the current detection device. Implementations in which the current detection devices are provided at two locations are described hereinafter in conjunction with the drawings. A current detected by the current detection device varies with the location of the current detection device. If a current detection device is provided at a branch where the photovoltaic string is located, the current detection device detects a current of the single photovoltaic string. If a current detection device is provided at a junction branch, the current detection device detects a current that is a sum of currents of multiple photovoltaic strings.

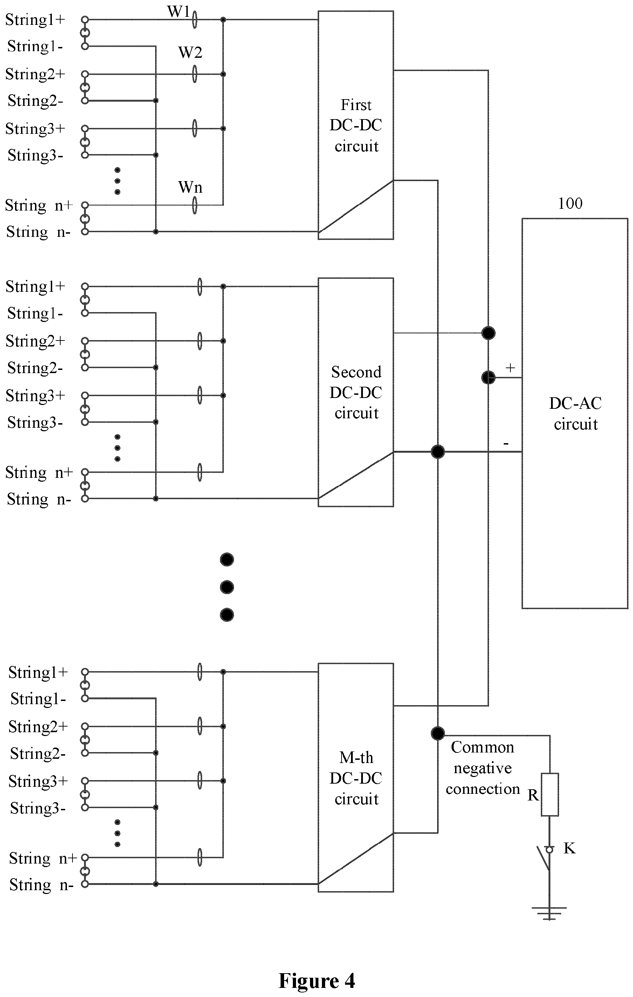

Reference is made to Figure 4, which is a schematic diagram of a photovoltaic power generation system in common negative connection according to an embodiment of the present disclosure.

The photovoltaic power generation system further includes a current limiting device, where the number of the current limiting device and the number of the switch are both one. The current limiting device and the switch are connected in series to form a branch, and the branch is connected between a negative input terminal or a negative output terminal of the corresponding DC-DC circuit and the ground. In the embodiment of the present disclosure, the current limiting device is, for example, the current limiting resistor R. In other embodiment, the current limiting device may be an inductor.

The implementation in which the current detection device is provided at a branch where the photovoltaic strings is located is described. The photovoltaic power generation system according to the embodiment of the present disclosure further includes at least n-1 current detection devices. Positive electrodes of the n photovoltaic strings are connected to each other. Each of the current detection devices is connected between a positive electrode of a corresponding photovoltaic string and a positive junction corresponding to the photovoltaic string, and the current detection device is configured to detect a current of a branch where the photovoltaic string is located. The controller is configured to determine, if a current of an i-th photovoltaic string is detected as positive, that the insulation fault occurs at a positive electrode of the i-th photovoltaic string to the ground, where the i-th photovoltaic string is one of the n photovoltaic strings. That is, the controller can locate the insulation fault just by a direction of the detected current of each of the photovoltaic strings.

As shown in Figure 4, each of the current detection devices is provided at a branch where a corresponding photovoltaic string is located, and is configured to detect a current of the single photovoltaic string. For example, the current detection devices W1, W2, ..., Wn corresponding to n photovoltaic strings connected to the first DC-DC circuit are provided at branches where corresponding photovoltaic strings are located respectively.

As shown in Figure 4, negative input terminals and negative output terminals of M DC-DC circuits are connected to each other, i.e., the M DC-DC circuits are in common negative connection.

A topology of the DC-DC circuit is not specifically limited in the embodiment of the present disclosure. For example, the DC-DC circuit may be a common two-level Boost circuit, or a three-level flying capacitor Boost circuit.

In the photovoltaic power generation system in common negative connection according to the embodiment of the present disclosure, the negative electrodes of all the photovoltaic strings have a same potential, and thus only one switch is provided to connect the negative electrodes and the ground. In this case, a current path is formed between a photovoltaic string where the insulation fault occurs and the ground, and each of the current detection devices for the photovoltaic strings acquires a current of a corresponding branch, so that the insulation fault can be located based on a direction of the current.

In another embodiment, the photovoltaic power generation system is not in common negative connection and the current detection devices are provided at branches where the photovoltaic strings are located, which is described hereinafter in conjunction with the drawings.

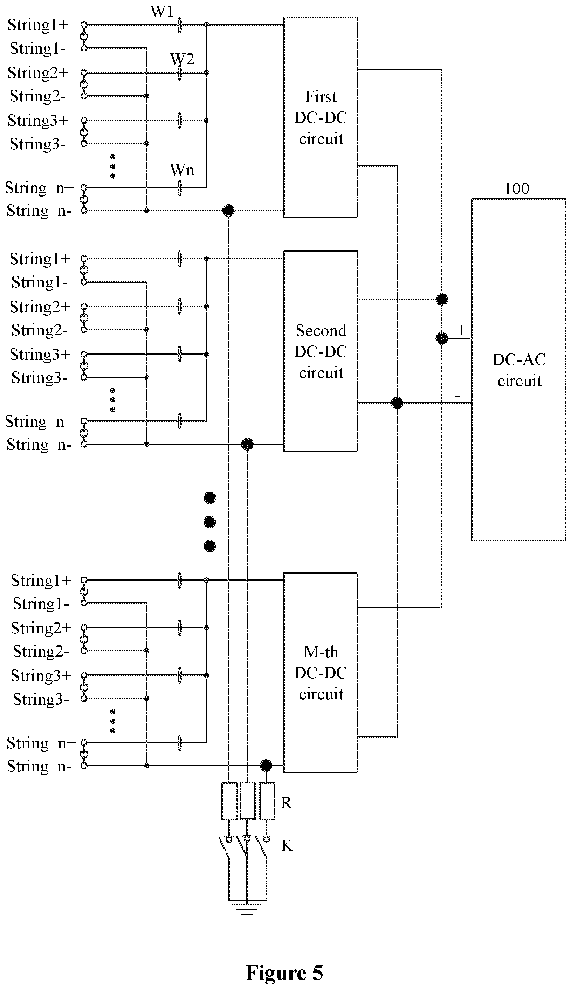

Reference is made to Figure 5, which is a schematic diagram of a photovoltaic power generation system not in common negative connection according to an embodiment of the present disclosure.

The photovoltaic power generation system according to the embodiment of the present disclosure further includes a current limiting device, where the number of the current limiting device, the number of the switch K and the number of the DC-DC circuit are equal. The current limiting device and the switch K are connected in series to form a branch, and the branch is connected between the negative input terminal of the DC-DC circuit and the ground. In the embodiment of the present disclosure, the current limiting device is, for example, the current limiting resistor R. In other embodiment, the current limiting device may be an inductor.

As shown in Figure 5, each of the current detection devices is provided at the branch where the corresponding photovoltaic string is located, and is configured to detect a current of the single photovoltaic string. For example, the current detection devices W1, W2, ..., Wn corresponding to n photovoltaic strings connected to the first DC-DC circuit are provided at branches where corresponding photovoltaic strings are located respectively.

Specifically, the controller is configured to determine, if a current of an i-th photovoltaic string is detected as positive and an absolute value of the current is maximum, that the insulation fault occurs at a positive electrode of the i-th photovoltaic string to the ground, where the i-th photovoltaic string is one of the n photovoltaic strings.

The photovoltaic power generation system shown in Figure 4 is different from the photovoltaic power generation system shown in Figure 5 in that for each of DC-DC circuits in Figure 5, a negative input terminal and a negative output terminal of the DC-DC circuit are disconnected from each other, negative electrodes of the photovoltaic strings connected to the DC-DC circuit are connected to each other, and negative input terminals of all of the DC-DC circuits are disconnected from each other, that is, the photovoltaic power generation system is not in common negative connection.

In the photovoltaic power generation system not in common negative connection, the negative input terminal and the negative output terminal of each of the DC-DC circuits are disconnected from each other. For example, the DC-DC circuit is a common symmetrical three-level Boost circuit, a diode is provided between the negative input terminal and the negative output terminal of the DC-DC circuit, and negative electrodes of photovoltaic strings connected to different DC-DC circuits are different in potential. In this case, no current path is formed between photovoltaic strings connected to normal DC-DC circuits where no insulation fault occurs and the ground, as shown in Figure 5. For each of the DC-DC circuits, a switch is provided at the negative input terminal of the DC-DC circuit, so that negative electrodes of the photovoltaic strings connected to the DC-DC circuit are grounded through the switch. The insulation fault is located based on directions of currents detected by the current detection devices. For example, if the photovoltaic power generation system in Figure 5 includes M DC-DC circuits, and M switches K are provided. The negative input terminal of each of the DC-DC circuits is grounded through the switch K and the current limiting resistor R connected in series. Compared with Figure 4, the photovoltaic power generation system in Figure 5 is provided with more switches. The photovoltaic power generation system in Figure 4 is only provided with one switch and one current limiting resistor.

The current detection devices in the above embodiments are provided at the branches where the photovoltaic strings are located. An implementation in which current detection devices are provided at junction branches is described hereinafter in conjunction with the drawings.

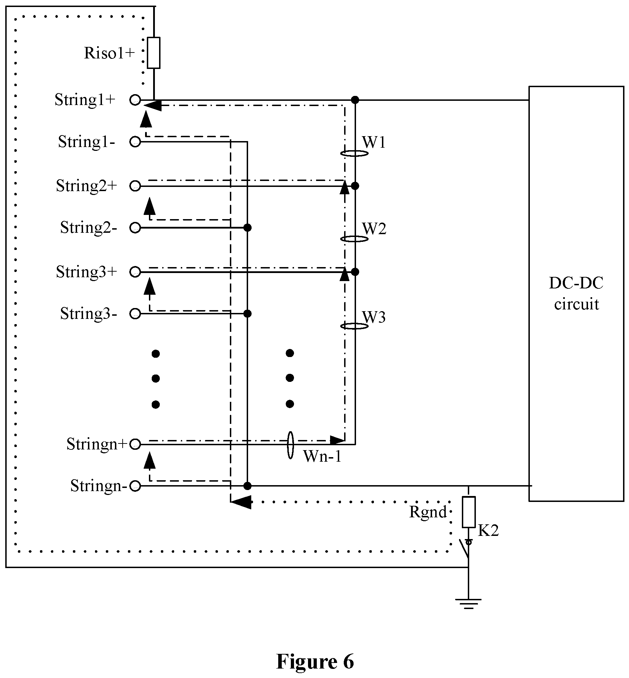

The photovoltaic power generation system according to the embodiment of the present disclosure further includes n-1 current detection devices. Positive electrodes of the n photovoltaic strings are connected to each other to form n-1 positive junctions. n-2 current detection devices among the n-1 current detection devices each are connected between two adjacent positive junctions among the n-1 positive junctions, and the remaining one current detection device (such as, the current detection device W1 in Figure 6) among the n-1 current detection devices is connected between a positive electrode of a first photovoltaic string and a positive junction corresponding to a second photovoltaic string.

Reference is made to Figure 6, which is a schematic diagram of a photovoltaic power generation system in common negative connection according to another embodiment of the present disclosure.

It can be seen from Figure 3 and Figure 6 that the location of the current detection device shown in Figure 3 is different from the location of the current detection device shown in Figure 6. A current detection device W2 is taken as an example. The current detection device W2 in Figure 3 detects a current of a branch where a second photovoltaic string connected to the first DC-DC circuit is located, while the current detection device W2 in Figure 6 detects a current that is a sum of currents of a first photovoltaic string and a second photovoltaic string that are connected to the first DC-DC circuit. Currents detected by other current detection devices are determined in a similar way, which are not described in detail herein.

For example, an insulation fault occurs at a positive electrode of one photovoltaic string connected to one DC-DC circuit in the photovoltaic power generation system to the ground. String n+ and String n- represents a positive electrode and a negative electrode of an n-th photovoltaic string respectively, W1 to Wn represent current detection devices provided at junction branches of the photovoltaic strings, Riso+ represents an equivalent impedance of the positive electrode to the ground, K represents the switch connected between the negative electrodes of the photovoltaic strings and the ground, and R represents the current limiting resistor connected to the switch in series.

Assuming that an insulation fault occurs at a positive electrode of a k-th (0<k<n) photovoltaic string, a current of each of the photovoltaic strings is In, and a direction of current flowing from the current detection device Wn to the positive electrode of the photovoltaic string is defined as a positive direction. The current flowing through the current detection device Wn is calculated as:

$$Wi=-(I1+\ldots+Ii) \quad i<k$$

$$Wi=I(i+1)+\ldots+In \quad i\geq k$$

For example, the DC-DC circuit is connected to five photovoltaic strings. If an insulation fault occurs at a positive electrode of the first photovoltaic string, the second photovoltaic string, the third photovoltaic string, the fourth photovoltaic string, or the fifth photovoltaic string to the ground, the currents detected by the current detection devices for various photovoltaic strings are shown in Table 2.

Table 2. Currents of photovoltaic strings if a short circuit occurs between a positive electrode of a photovoltaic string and the ground

| | W1 | W2 | W3 | W4 |
|---|---|---|---|---|
| First photovoltaic string | 2.0A | 1.5A | 1.0A | 0.5A |
| Second photovoltaic string | -0.5A | 1.5A | 1.0A | 0.5A |
| Third photovoltaic string | -0.5A | -1.0A | 1.0A | 0.5A |
| Fourth photovoltaic string | -0.5A | -1.0A | -1.5A | 0.5A |
| Fifth photovoltaic string | -0.5A | -1.0A | -1.5A | -2.0A |

Further, Vpv represents an input voltage of the DC-DC circuit, W(i-1) and Wi represent currents detected by two current detection devices connected to the photovoltaic string where the insulation fault occurs respectively, and R represents resistance of a current limiting resistor connected to the switch in series. An impedance Riso+ of the positive electrode to the ground may be calculated according to Ohm's law as:

$$Riso+=Vpv/(Wi+|W(i-1)|)-R$$

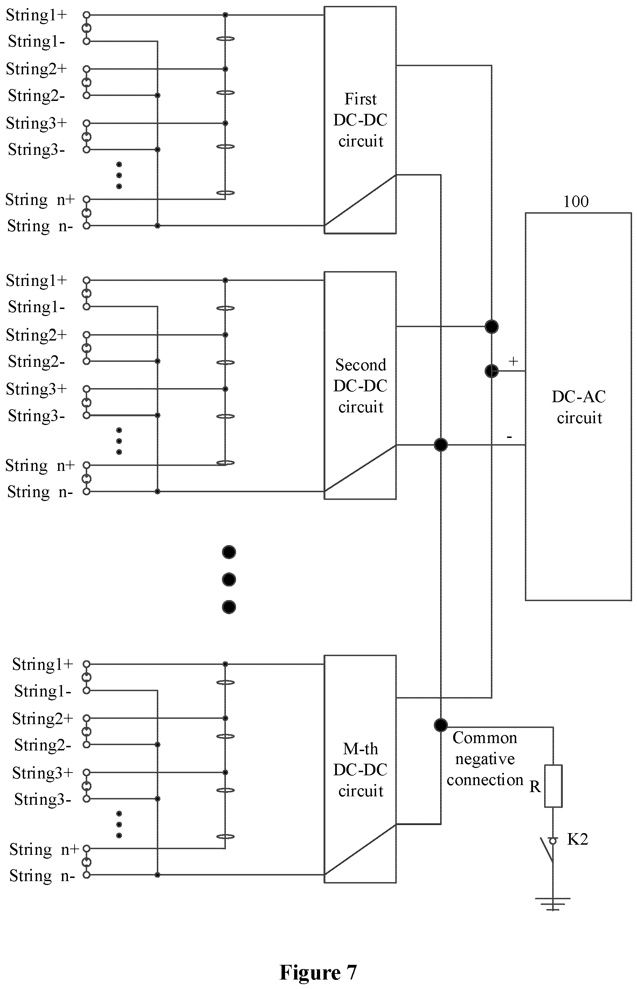

Figure 6 shows an example of one DC-DC circuit in the photovoltaic power generation system. It should be understood that, the photovoltaic power generation system is in common negative connection, and negative input terminals and negative output terminals of all the DC-DC circuits are connected to each other. Reference is made to Figure 7, which is a schematic diagram of a photovoltaic power generation system including multiple DC-DC circuits in common negative connection. It should be understood that, an insulation fault is located in a same way as that for the single DC-DC circuit in Figure 6.

In the photovoltaic power generation system in Figure 7, the negative input terminals and the negative output terminals of the DC-DC circuits have a same potential, each of the DC-DC circuits is a two-level Boost circuit, a three-level flying capacitor Boost circuit or the like. The negative electrodes of all the photovoltaic strings have a same potential, and thus only one switch is provided to connect the negative electrodes and the ground. In this case, a current path is formed between a photovoltaic string where the insulation fault occurs and the ground. Each of the current detection devices for the photovoltaic strings acquires a current of a corresponding branch, and the insulation fault is located in the way described hereinabove.

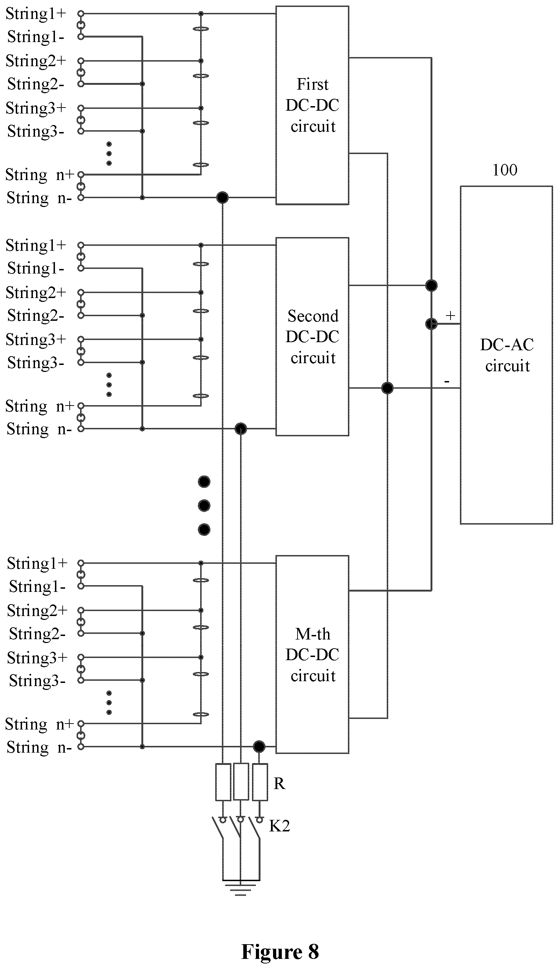

In a photovoltaic power generation system not in common negative connection according to the embodiments of the present disclosure, the current detection devices may be provided at junction branches. In a photovoltaic power generation system shown in Figure 8, a diode or other component is provided at a negative electrode of each of the DC-DC circuits (such as, a symmetrical three-level Boost circuit). As a result, negative electrodes of photovoltaic strings connected to different DC-DC circuits are different in potential, and a negative input terminal of each of the DC-DC circuits is grounded through a switch.

In the photovoltaic power generation system according to the embodiments of the present disclosure, if an insulation fault occurs at the positive electrode of the photovoltaic power generation system to the ground, the insulation fault can be located at a specific photovoltaic string, which is suitable for a scenario that multiple DC-DC circuits are connected to one DC-AC circuit in the photovoltaic power generation system. Furthermore, current detection devices in the photovoltaic power generation system may be directly used, only the current limiting resistor and the switch are additionally provided, so that hardware is easy to implement and has low cost. Moreover, the impedance to ground is calculated based on a photovoltaic voltage and currents of the photovoltaic strings already detected in the photovoltaic power generation system, further improving the detection precision of the insulation impedance.

Based on the photovoltaic power generation system according to the above embodiments, an insulation detection method is further provided according to an embodiment of the present disclosure, which is described in detail hereinafter in conjunction with the drawings.

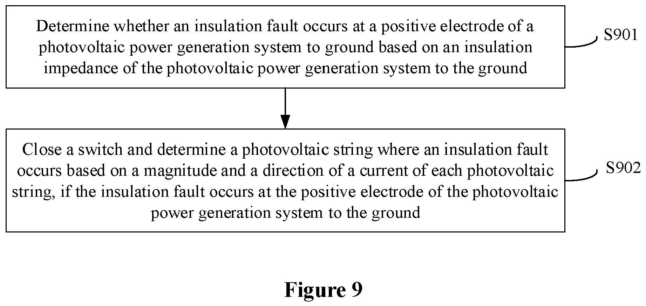

Reference is made to Figure 9, which is a flowchart of an insulation detection method for a photovoltaic power generation system according to an embodiment of the present disclosure.

In the insulation detection method for a photovoltaic power generation system according to the embodiment of the present disclosure, the photovoltaic power generation system includes a switch, a DC-AC circuit and at least one DC-DC circuit. An input end of each of the at least one DC-DC circuit is configured to connect n photovoltaic strings, n is an integer greater than or equal to two, and an output end of the at least one DC-DC circuit is connected to an input end of the DC-AC circuit. Negative electrodes of all the photovoltaic strings are grounded through the switch. The method includes the following steps S901 and 5902.

In step S901, it is determined whether an insulation fault occurs at a positive electrode of the photovoltaic power generation system to ground based on an insulation impedance of the photovoltaic power generation system to the ground.

In step S902, if the insulation fault occurs at the positive electrode of the photovoltaic power generation system to the ground, the switch is closed and a photovoltaic string where the insulation fault occurs is determined based on a magnitude and a direction of a current of each of the photovoltaic strings.

A solution for determining a photovoltaic string where the insulation fault to the ground occurs is provided according to the embodiment of the present disclosure as follows. If it is detected that an insulation fault occurs at a positive electrode of the photovoltaic power generation system to the ground, the photovoltaic power generation system is controlled to stop operating, negative electrodes of all the photovoltaic strings are controlled to be grounded, and the photovoltaic string where the insulation fault to the ground occurs is directly determined based on a magnitude and a direction of a current of each of the photovoltaic strings.

It should be understood that, if an insulation fault occurs at the photovoltaic power generation system to the ground, it is determined whether the insulation fault occurs based on an insulation impedance of the photovoltaic power generation system to the ground. For example, if the insulation impedance of the photovoltaic power generation system to the ground is less than a preset impedance, it indicates that the insulation fault occurs. According to the embodiment of the present disclosure, if the insulation fault occurs at the positive electrode of the photovoltaic power generation system, the insulation fault is further accurately located.

If the insulation fault occurs at the positive electrode of the photovoltaic power generation system, the negative electrodes of all the photovoltaic strings are controlled to be grounded, and a short circuit occurs between a positive electrode of a photovoltaic string where the insulation fault occurs and the ground. As a result, a current path is formed between the positive electrode of the photovoltaic string and the ground, and currents of other photovoltaic strings flow into the photovoltaic string where the insulation fault occurs, in a direction opposite to a direction of a current of the photovoltaic string where the insulation fault occurs. Therefore, the photovoltaic string where the insulation fault occurs can be determined by detecting the magnitude and the direction of the current of each of the photovoltaic strings according to the embodiments of the present disclosure.

In an embodiment, the photovoltaic power generation system further includes at least n-1 current detection devices. Positive electrodes of the n photovoltaic strings are connected to each other. Each of the at least n-1 current detection devices is connected between a positive electrode of a corresponding photovoltaic string and a positive junction corresponding to the photovoltaic string, and the current detection device is configured to detect a current of a branch where the photovoltaic string is located.

The photovoltaic string where the insulation fault occurs is determined based on the magnitude and the direction of the current of each of the photovoltaic strings by: determining, if a current of an i-th photovoltaic string is detected as positive, that the insulation fault occurs at a positive electrode of the i-th photovoltaic string to the ground, where the i-th photovoltaic string is one of the n photovoltaic strings.

In an embodiment, the photovoltaic power generation system further includes n-1 current detection devices. Positive electrodes of the n photovoltaic strings are connected to each other to form n-1 positive junctions, n-2 current detection devices among the n-1 current detection devices each are connected between two adjacent positive junctions among the n-1 positive junctions, and the remaining one current detection device among the n-1 current detection devices is connected between a positive electrode of a first photovoltaic string and a positive junction corresponding to a second photovoltaic string.

The photovoltaic string where the insulation fault occurs is determined based on the magnitude and the direction of the current of each of the photovoltaic strings by: determining, if a current of an i-th photovoltaic string is detected as positive and an absolute value of the current is maximum, that the insulation fault occurs at a positive electrode of the i-th photovoltaic string to the ground, where the i-th photovoltaic string is one of the n photovoltaic strings.

With the insulation detection method for a photovoltaic power generation system according to the embodiments of the present disclosure, if an insulation fault occurs at a positive electrode of the photovoltaic power generation system to the ground, the insulation fault can be located at a specific photovoltaic string, which is suitable for a scenario that multiple DC-DC circuits are connected to one DC-AC circuit in the photovoltaic power generation system. Furthermore, current detection devices in the photovoltaic power generation system may be directly used, only the current limiting resistor and the switch are additionally provided, so that hardware is easy to implement and has low cost. Moreover, the impedance to ground is calculated based on a photovoltaic voltage and currents of the photovoltaic strings already detected in the photovoltaic power generation system, further improving the detection precision of the insulation impedance.

It should be noted that, various embodiments in this specification are described in a progressive manner. Each of the embodiments focuses on its differences from other embodiments, and references may be made among these embodiments with respect to the same or similar parts. Since the system or device disclosed in the embodiments corresponds to the method disclosed in the embodiments, the description of the system or device is relatively simple, and reference may be made to the description of the method for relevant parts.

Based on the above description of the disclosed embodiments, those skilled in the art can carry out or use the present disclosure. It is apparent for those skilled in the art to make many modifications to these embodiments. The general principle defined herein may be applied to other embodiments without departing from scope of the present disclosure. Therefore, the present disclosure is not limited to the embodiments illustrated herein, but should be defined by the broadest scope consistent with the principle and novel features disclosed herein.

**Claims**

1. A photovoltaic power generation system, comprising

   a switch;
   a direct current-alternating current, DC-AC, circuit;
   a controller and
   at least one DC-DC circuit, wherein
   an input end of each of the at least one DC-DC circuit is configured to connect n photovoltaic strings, wherein n is an integer greater than or equal to two;
   an output end of the at least one DC-DC circuit is connected to an input end of the DC-AC circuit;
   negative electrodes of all the photovoltaic strings are grounded through the switch; and the controller is configured to close the switch and determine a photovoltaic string where an insulation fault occurs based on a magnitude and a direction of a current of each of the n photovoltaic strings, if the insulation fault occurs at a positive electrode of the photovoltaic power generation system to ground.

2. The photovoltaic power generation system according to claim 1, further comprising at least n-1 current detection devices, wherein

   positive electrodes of the n photovoltaic strings are connected to each other; and
   each of the at least n-1 current detection devices is connected between a positive electrode of a corresponding photovoltaic string and a positive junction corresponding to the photovoltaic string, and the current detection device is configured to detect a current of a branch where the photovoltaic string is located.

3. The photovoltaic power generation system according to claim 2, wherein the controller is configured to determine, if a current of an i-th photovoltaic string is detected as negative, that the insulation fault occurs at a positive electrode of the i-th photovoltaic string to the ground, wherein the i-th photovoltaic string is one of the n photovoltaic strings.

4. The photovoltaic power generation system according to claim 1, further comprising n-1 current detection devices, wherein

   positive electrodes of the n photovoltaic strings are connected to each other to form n-1 positive junctions; and
   n-2 current detection devices among the n-1 current detection devices each are connected between two adjacent positive junctions among the n-1 positive junctions, and the remaining one current detection device among the n-1 current detection devices is connected between a positive electrode of a first photovoltaic string and a positive junction corresponding to a second photovoltaic string.

5. The photovoltaic power generation system according to claim 4, wherein the controller is configured to determine, if a current of an i-th photovoltaic string is detected as positive and an absolute value of the current is maximum, that the insulation fault occurs at a positive electrode of the i-th photovoltaic string to the ground, wherein the i-th photovoltaic string is one of the n photovoltaic strings.

6. The photovoltaic power generation system according to claim 3 or 5, wherein a negative input terminal and a negative output terminal of the at least one DC-DC circuit are connected to each other.

7. The photovoltaic power generation system according to claim 3 or 5, wherein a negative input terminal and a negative output terminal of the at least one DC-DC circuit are disconnected from each other.

8. The photovoltaic power generation system according to claim 6 or 7, further comprising a current limiting device, wherein

   the number of the current limiting device, the number of the switch and the number of the at least one DC-DC circuit are equal to each other; and
   the current limiting device and the switch are connected in series in one-to-one correspondence to form a branch, and the branch is connected between the negative input terminal of the corresponding DC-DC circuit and the ground.

9. The photovoltaic power generation system according to claim 6, further comprising a current limiting device, wherein

   the number of the current limiting device and the number of the switch each are one; and
   the current limiting device and the switch are connected in series to form a branch, and the branch is connected between the negative input terminal or the negative output terminal of the at least one DC-DC circuit and the ground.

10. An insulation detection method for a photovoltaic power generation system, wherein

    the photovoltaic power generation system comprises a switch, a direct current-alternating current, DC-AC, circuit and at least one DC-DC circuit, wherein an input end of each of the at least one DC-DC circuit is configured to connect n photovoltaic strings, n is an integer greater than or equal to two; an output end of the at least one DC-DC circuit is connected to an input end of the DC-AC circuit; and negative electrodes of all the photovoltaic strings are grounded through the switch,

wherein the insulation detection method comprises:

closing the switch and determining a photovoltaic string where the insulation fault occurs based on a magnitude and a direction of a current of each of the n photovoltaic strings, if the insulation fault occurs at the positive electrode of the photovoltaic power generation system to the ground.

11. The insulation detection method according to claim 10, wherein

the photovoltaic power generation system further comprises at least n-1 current detection devices, positive electrodes of the n photovoltaic strings are connected to each other, each of the at least n-1 current detection devices is connected between a positive electrode of a corresponding photovoltaic string and a positive junction corresponding to the photovoltaic string, and the current detection device is configured to detect a current of a branch where the photovoltaic string is located,

wherein, the determining a photovoltaic string where the insulation fault occurs based on a magnitude and a direction of a current of each of the n photovoltaic strings comprises:

determining, if a current of an i-th photovoltaic string is detected as positive, that the insulation fault occurs at a positive electrode of the i-th photovoltaic string to the ground, wherein the i-th photovoltaic string is one of the n photovoltaic strings.

12. The insulation detection method according to claim 10, wherein

the photovoltaic power generation system further comprises n-1 current detection devices, positive electrodes of the n photovoltaic strings are connected to each other to form n-1 positive junctions; n-2 current detection devices among the n-1 current detection devices each are connected between two adjacent positive junctions of the n-1 positive junctions, and the remaining one current detection device among the n-1 current detection devices is connected between a positive electrode of a first photovoltaic string and a positive junction corresponding to a second photovoltaic string; and

wherein, the determining a photovoltaic string where the insulation fault occurs based on a magnitude and a direction of a current of each of the n photovoltaic strings comprises:

determining, if a current of an i-th photovoltaic string is detected as positive and an absolute value of the current is maximum, that the insulation fault occurs at a positive electrode of the i-th photovoltaic string to the ground, wherein the i-th photovoltaic string is one of the n photovoltaic strings.

String1+
String1-
String2+
String2-
String3+
String3-

String n+
String n-

First
DC-DC
circuit

String1+
String1-
String2+
String2-
String3+
String3-

String n+
String n-

Second
DC-DC
circuit

String1+
String1-
String2+
String2-
String3+
String3-

String n+
String n-

M-th
DC-DC
circuit

100

DC-AC
circuit

+

-

**Figure 1**

**Figure 2**

**Figure 3**

**Figure 4**

**Figure 5**

**Figure 6**

**Figure 7**

**Figure 8**

Determine whether an insulation fault occurs at a positive electrode of a photovoltaic power generation system to ground based on an insulation impedance of the photovoltaic power generation system to the ground — S901

Close a switch and determine a photovoltaic string where an insulation fault occurs based on a magnitude and a direction of a current of each photovoltaic string, if the insulation fault occurs at the positive electrode of the photovoltaic power generation system to the ground — S902

**Figure 9**

Europäisches
Patentamt

European
Patent Office

Office européen
des brevets

# EUROPEAN SEARCH REPORT

Application Number

EP 24 20 2890

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 219 780 105 U (SUNGROW POWER SUPPLY CO LTD) 29 September 2023 (2023-09-29) * claims 1-12; figures 1-6 * | 1-12 | INV. H02S50/10 |
| X | US 2023/396057 A1 (ZHANG FANGPO [CN] ET AL) 7 December 2023 (2023-12-07) * paragraphs [0048] - [0134]; claims 21-38; figures 1a-11 * | 1-12 | |

TECHNICAL FIELDS
SEARCHED      (IPC)

H02S

The present search report has been drawn up for all claims

| Place of search | Date of completion of the search | Examiner |
|---|---|---|
| The Hague | 5 March 2025 | Boero, Mauro |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

   ........................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 20 2890

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2025

| Patent document cited in search report | | Publication date | Patent family member(s) | | Publication date |
|---|---|---|---|---|---|
| CN 219780105 | U | 29-09-2023 | CN | 219780105 U | 29-09-2023 |
| | | | CN | 221227496 U | 25-06-2024 |
| | | | DE | 202024100357 U1 | 01-02-2024 |
| US 2023396057 | A1 | 07-12-2023 | AU | 2021428448 A1 | 21-09-2023 |
| | | | CN | 113725847 A | 30-11-2021 |
| | | | CN | 116615851 A | 18-08-2023 |
| | | | CN | 119401935 A | 07-02-2025 |
| | | | EP | 4287503 A1 | 06-12-2023 |
| | | | US | 2023396057 A1 | 07-12-2023 |
| | | | WO | 2022174402 A1 | 25-08-2022 |

EPO FORM P0459

For more details about this annex : see Official Journal of the European Patent Office, No. 12/82